(19) Europäisches Patentamt

European Patent Office

Office européen des brevets

(11) **EP 1 396 913 A1**

## (12) EUROPEAN PATENT APPLICATION

(43) Date of publication:
**10.03.2004 Bulletin 2004/11**

(51) Int Cl.7: **H01S 5/0625**

(21) Application number: **02256117.9**

(22) Date of filing: **03.09.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(71) Applicant: **Agilent Technologies, Inc. - a Delaware corporation -**
**Palo Alto, CA 94303-0870 (US)**

(72) Inventors:
• **Massara, Aeneas Benedict**
**Diss, Norfolk, IP22 5SQ (GB)**

• **Moseley, Richard William**
**Ipswich, Suffolk IP4 1NT (GB)**
• **Silver, Mark**
**Ipswich, Suffolk, IP2 9AT (GB)**
• **Plumb, Richard Gordon Samuel**
**Ipswich, Suffolk, IP8 3QQ (GB)**

(74) Representative: **Coker, David Graeme et al**
**Agilent Technologies UK Ltd,**
**Legal Dept,**
**Eskdale Road,**
**Winnersh Triangle**
**Wokingham, Berks RG41 5DZ (GB)**

### (54) Single mode distributed feedback lasers

(57) The present invention relates to solid state distributed feedback (DFB) lasers in which a phase shift is introduced to optical radiation circulating in a laser cavity in order to stabilise the laser into single mode operation. A solid state single mode distributed feedback (DFB) laser (1), comprises a laser waveguide (10), a DFB grating structure (6) optically coupled to the waveguide (10) for stabilising the wavelength of optical radiation (7) in the waveguide (10), one or more current conduction regions (4',4") for guiding an applied electrical current to pump the laser waveguide (10) and at least one current constriction region (40) adjacent the one or more current conduction regions (4',4"). The DFB structure (6) extends in the current constriction region (40) and at least one of the current conduction regions (4',4"). The current conduction and constriction regions (4',4",40) are arranged so that an electrical current (34) applied to the current conduction region(s) (4',4") pumps the laser waveguide (10) preferentially in the current conduction regions (4',4") compared with the electrical constriction region (40) and thus varies the effective index of refraction (38) of the laser waveguide (10) in these regions (4',4",40) in order to stabilise the optical radiation (7) for single mode operation of the laser (1).

*Fig. 1*

EP 1 396 913 A1

**Description**

The present invention relates to solid state distributed feedback (DFB) lasers in which a phase shift is introduced to optical radiation circulating in a laser cavity in order to stabilise the laser into single mode operation.

It is well-known that index coupled solid state DFB lasers, with a regular grating structure formed by alternating regions of high and low refractive index, have an inherent spectral yield in that not all devices operate with a single mode. In a laser cavity having opposite antireflection coated output facets, the regular structure results in zero gain at the exact wavelength $\lambda_0$ corresponding to the grating period of $\lambda_0/2$, owing to destructive interference between different multiple reflections across a high/low index of refraction grating. The result is that the structure is capable of stabilizing the wavelength at two wavelengths above and below the exact grating wavelength $\lambda_0$. Such a laser will therefore generate two modes at wavelengths $\lambda_0 \pm \Delta\lambda$.

In such an antireflection coated laser, the destructive interference effect at the wavelength $\lambda_0$ can be disrupted by introducing a phase shift in the period of the DFB grating, for example a $\lambda_0/4$ phase shift at a midpoint along the length of the grating. An example of this is disclosed in K. Sekartedjo, Electronic Letters, vol. 20, pp. 82-84, (1984). Such a laser will then operate in a single mode with a wavelength $\lambda$ at or near grating wavelength $\lambda_0$. However, the formation of such a non-regular structure may involve expensive and relatively slow e-beam fabrication steps.

One or two reflection coated facets can be used to introduce an analogous phase shift with a regular non-phase shifted DFB grating. If the position of an output facet relative to the grating corresponds with a $\lambda_0/4$ phase shift, then the wavelength of light emitted from the opposite output facet will also be stabilised, with a single mode, at or near the $\lambda_0$ wavelength.

The facets of solid state DFB lasers are normally formed by cleaving. It is not easy to control the exact cleave position with respect to the grating position, with the result that there will be a random phase shift anywhere between 0° and 360° in the position of the facets relative to the grating position. For cleave positions close to 0° and 360° there will be no mode stabilisation. It is not necessary for the phase shift introduced by a reflecting facet to be exactly $\lambda_0/4$, and in practice it has been found that for a random cleave position up to 80% of solid state DFB lasers can be stabilised for single mode operation. This, however, results in a 20% yield loss for those lasers that operate with two modes.

A number of other solutions have therefore been proposed for the mode stabilisation problem in solid state DFB lasers.

One proposed solution is to change over a central region of the DFB structure the base refractive index in which the index grating structure is formed, while keeping the grating period constant across the entire DFB structure. This can be done in such a way as to break the destructive interference that results in two mode operation. This, however, involves an additional process step to create the change in the base index of refractive, for example by ion implantation.

A second approach, disclosed in H. Soda *et al.*, IEEE Journal of Quantum Electronics, vol. QE-23, no. 6, pp. 804-814 (1987), is to vary the effective index of refraction experienced by the optical radiation guided along the DFB structure by changing the lateral width of a guiding mesa structure in a central portion of the DFB pattern. This however has the disadvantages of requiring precise control of the mesa width, and possible waveguide losses owing to a narrow mesa width or the changes in mesa width.

A third approach, disclosed in J.I. Shim *et al.*, Electronic Letters, vol. 30, no. 25, pp. 2130-2131 (1994), is to vary the effective index of refraction experienced by the optical radiation guided along the DFB structure by selective area growth in a central portion of the DFB pattern. This, however, involves extra masking and growth steps, and well as introducing the complication that the grating pattern may have to be defined on a non-planar surface. As a result, this type of structure may require a long central phase-shift section, including controlled transition regions.

A fourth proposed solution, disclosed in S. Koentjoro *et al.*, Japanese Journal of Applied Physics, vol. 23, no. 10, L791-794, (1984), involves the addition of a groove region in a central portion of the waveguide prior to the deposition of the grating pattern. This is similar to the third approach described above in that this creates a central region having a waveguide thickness that differs from adjacent regions. This suffers from similar problems to those of the third approach.

A fifth approach, disclosed in H. Hillmer *et al.*, Electronics Letters, vol. 30, no. 18, pp. 1483-1484 (1994), is to create a section of waveguide with a different base index of refraction by forming a waveguide with a bend at which the effective index varies from adjacent straight sections of waveguide. This avoids the difficulties associated with a varying width or thickness of waveguide, but requires the curved waveguide to be quite long (>50 $\mu$m). Bent waveguides can also lead to large optical losses.

A sixth approach, disclosed in J.I. Shim *et al.*, Electronics Letters, vol. 25, no. 24, pp. 1654-1656, (1989), is to create a continuous regular grating that has two distinct grating regions. The first grating region is formed in alternating areas of low and high refractive index, respectively $n_1$ and $n_2$. The second grating region is formed in alternating areas of low and high refractive index, respectively $n_2$ and $n_3$. Since $n_1 > n_2 > n_3$ the resultant grating has a 180° phase change at the interface between the grating for between n1 and $n_2$ and between $n_2$ and $n_3$. This type of structure can be formed by using holographic lithography; however, the two grating regions will have different grating strengths. In addition the refractive index steps must be introduced with different band-gap materials. This can cause unwanted blocking hetero-interfaces throughout the grating regions.

It is an object of the invention to provide a more convenient solid state single mode distributed feedback laser.

According to the invention, there is provided a solid state single mode distributed feedback (DFB) laser, comprising a laser waveguide, a DFB grating structure optically coupled to the waveguide for stabilising the wavelength of optical radiation in the waveguide, one or more current conduction regions for guiding an applied electrical current to pump the laser waveguide and at least one current constriction region adjacent said one or more current conduction regions, said DFB structure extending in said current constriction region and at least one of said current conduction regions, wherein the current conduction and constriction regions are arranged so that an electrical current applied to the current conduction region(s) pumps the laser waveguide preferentially in said one or more current conduction regions compared with the electrical constriction region and thus varies the effective index of refraction of the laser waveguide in said regions in order to stabilise said optical radiation for single mode operation of the laser.

The laser may be formed from using III-V semiconductor materials, such as GaAs and InP.

Because the pumping current generates areas of different base refractive index, the invention avoids many of the difficulties associated with various prior art approaches to creating a single mode DFB solid state laser. For example, in a preferred embodiment of the invention, the DFB structure is based on a regular periodic array of partially reflective features. The DFB structure can then be formed from regions of varying index of refraction that partly reflect and transmit incident optical radiation within the laser waveguide. The effective period of the regular grating then varies according to the variation in the base refractive index, owing to the change in the physical wavelength within the waveguide owing to the base refractive index change.

One or more current constriction regions can be formed in various different ways, for example by incorporating an insulating or semi-insulating layer of structure, which may include either III-V semiconductor materials or inorganic glass-like barrier layers, such as aluminium oxide or silicon nitride.

Other ways in which a current constriction region can be formed are by using a wet chemical etching process, a dry etching process such as ion bombardment, for example, to remove material that may otherwise be incorporated in a current conduction region, or by ion implantation, for example to alter the properties of material that would otherwise function as a current conduction region.

Therefore, the current constriction region may be ion implanted to increase the electrical resistivity of the current constriction region relative to said adjacent current conduction region.

In a preferred embodiment of the invention, the current conduction region is formed from one or more semiconductor layers deposited above the laser waveguide. It may be helpful if at least one of these deposited layers do not extend over the current constriction region.

The DFB laser may include one or more electrical contacts for applying the electrical current. The contacts may then extend over the current conduction regions but not over said current constriction region.

In a preferred embodiment of the invention, one current constriction region lies between two adjacent current conduction regions. Preferably both of these two adjacent current conduction regions have an electrical contact for applying an electrical current. These two electrical contacts may be in direct electrical connection with each other, for example by a wire or track that extends between the two areas. Equivalently, there may be one electrical contact shaped so that this extends over two distinct current conduction regions.

Also according to the invention, there is provided a method of forming a solid state single mode distributed feedback (DFB) laser, said laser having a semiconductor substrate and a plurality of layers deposited above said substrate, the method comprising the steps of forming in said deposited layers:

  a) a laser waveguide;

  b) one or more current conduction regions above said laser waveguide for guiding an applied electrical current to pump the laser waveguide;

  c) at least one current constriction region above said laser waveguide and adjacent said one or more current conduction regions;

  d) a DFB grating structure optically coupled to the waveguide for stabilising the wavelength of optical radiation in said waveguide, said structure extending in said current constriction region and at least one of said current conduction regions;

wherein said one or more current conduction regions and said at least one current constriction region have the characteristic that electrical current applied to said current conduction region(s) pumps the laser waveguide preferentially in said one or more current conduction regions compared with said at least one electrical constriction region in order to vary the effective index of refraction of the laser waveguide in said regions in order to stabilise said optical radiation for single mode operation of the laser.

The invention further provides a method of operating a solid state distributed feedback (DFB) laser, said laser having a laser waveguide, a DFB grating structure optically coupled to the waveguide for stabilising the wavelength of optical radiation in the waveguide, one or more current conduction regions for guiding an applied electrical current to pump the laser, the current conduction region(s) extending only within a portion of the DFB grating structure, wherein the method comprises applying through said one or more current conduction regions an electrical current to pump the laser waveguide unevenly with respect to the extent of the DFB structure and thus vary the effective index of refraction of the laser waveguide in order to stabilise said optical radiation for single mode operation of the laser.

The invention will be further described, by way of example only, and with reference to the accompanying drawings, in which:

Figure 1 is a schematic diagram showing a longitudinal cross-section through a solid state single mode distributed feedback (DFB) laser according to the invention, comprising a laser waveguide, a DFB grating structure optically coupled to the waveguide for stabilising the wavelength of optical radiation in the waveguide, and a central current constriction region flanked by two adjacent current conduction regions; and

Figure 2 is a plot showing how for the laser of Figure 1, the current is guided preferentially in the current conduction regions compared with the current confinement region.

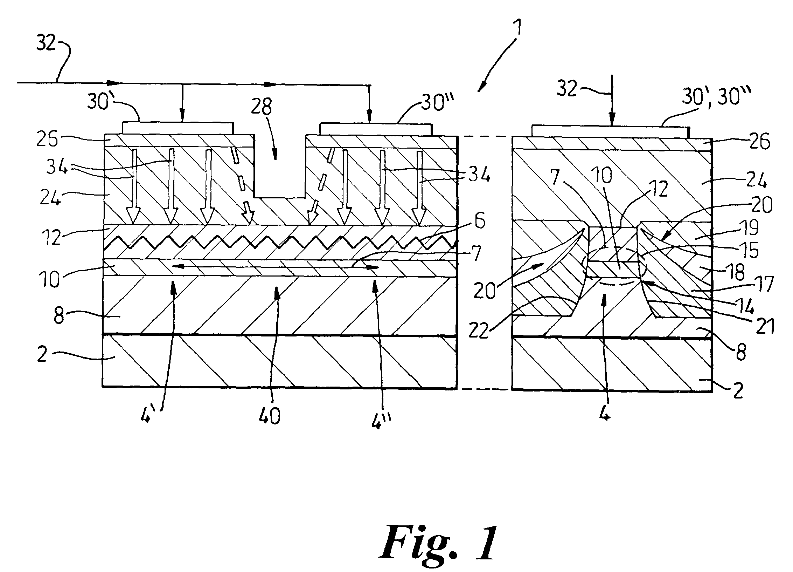

Figure 1 shows schematically and not to scale, a longitudinal cross-section through a III-V solid state single mode distributed feedback (DFB) laser device 1. The laser device 1 includes a buried heterostructure, indicated generally by reference numeral 14, suitable for use as a transmitter in a high speed fibre-optic link operating between 1.27 and 1.6 $\mu$m. Currently, high speed links operate at 1, 2.5 or 10 Gbits/s.

The device 1 is formed starting from a wafer that is around 50 mm in diameter, and that has an n-InP substrate 2 doped to around $10^{19}$ cc$^{-1}$, on which is grown a number of n-type and p-type III-V semiconductor layers, using well-known MOCVD techniques. The p-type dopant is zinc, and the n-type dopant is sulphur.

The first grown layer is a 2 $\mu$m thick n$^-$-InP buffer layer 8 doped to around $10^{18}$ cc$^{-1}$. An active layer 10 is grown on the buffer layer 8 according to known techniques for fabricating planar active lasers for a laser diode - the active layer could be a bulk region or a strained multiple quantum well (SMQW) structure. An example of an SMQW device is discussed in W. S. Ring et al, Optical Fibre Conference, Vol. 2, 1996 Technical Digest Series, Optical Society of America.

In the present example, the laser device 1 has a quaternary $In_xGa_{1-x}As_{1-y}P_y$ active layer 10 that may be between about 100 nm to 300 nm thick. The active layer 10 is topped by a cladding layer 12, formed from p$^+$-InP, grown to be between about 100 nm to 1 $\mu$m thick.

A DFB grating 6 for the laser device 1 is contained in the p-InP cladding layer 12 by forming alternating layers of high and low refractive index. Alternatively, the DFB grating 6 could be formed in the n-InP buffer layer 8. In either case, the DFB grating 6 interacts optically with optical radiation 7 generated by the active layer 10.

Then, using well-known fabrication technology, the wafer is photolithographically patterned with a photoresist to leave a patterned mask, and etched to remove, in areas not covered by the patterned mask, the cladding layer 12, the active layer 10, and part of the buffer layer 8.

The grown layers 8,10 and 12 are removed in all areas except along a mesa stripe 14 structure which rises above the level of the substrate 2. The mesa stripe 14 has left and right opposite side walls 21,22 that together with the buffer layer 8 and the cladding 12 form a current conduction region 4 for an applied current 34 (I), and have the effect of guiding an optical mode 15 along the active layer 10 within the stripe 14.

The width of the mesa stripe 14 varies depending on the particular device, but for opto-electronic devices such as laser diodes, the ridge stripe 14 is usually between 1 $\mu$m and 3 $\mu$m wide. The ridge strip 14 rises 1 $\mu$m to 2 $\mu$m above the surrounding substrate 2.

A current confinement or blocking structure 20 is then grown on the etched device up to approximately the level of a patterned mask (not shown) that covers the mesa 14. The structure 20 includes a number of layers adjacent the buffer layer 8 including a first p-doped InP layer 17 having a dopant concentration about $1 \times 10^{18}$ cc$^{-1}$ and above this, an n-doped In-P layer having a dopant concentration of at least about $1 \times 10^{18}$ cc$^{-1}$. The n-doped InP layer 18 preferably has a substantially constant dopant concentration at least as high as the highest dopant concentration in the p-type layer 17.

The thicknesses of the n-doped layer 18 is about 0.5 $\mu$m and the thickness of the p-doped layer 17 is about 0.4 $\mu$m. These InP layers 17,18 form a p-n junction that in use is reverse biased and hence insulating when the conduction region 4 is forward biased.

A second p-doped InP layer 19 having a dopant concentration about $1 \times 10^{18}$ cc$^{-1}$ is then grown over the n-doped layer 18 up to approximately the level of the cladding layer 12.

After deposition of the semiconductor layers 17,18,19 used to form the current confinement structure 20, the oxide mask is removed with 10:1 buffered HF from the mesa strip 14 to expose again the cladding layer 12. This leaves an etched and coated wafer comprising the substrate 2, the mesa stripe 14 and the layers 17,18,19 abutting the opposite sides 21,22 of the mesa stripe 14.

An upper cladding layer 24 formed from highly doped p$^+$-InP is then grown above the cladding layer 12 and the layers 17,18,19 used to form the current confinement structure 20, up to a thickness of about 1.5 μm to 3 μm. The final semiconductor layer is a 100 nm to 200 nm thick ternary cap layer 26 deposited on the upper cladding layer 24. The cap layer 26 is formed from p++-GaInAs, very highly doped to greater than $10^{19}$ cc-1, in order to provide a good low resistance ohmic contact for electrical connection to the current conduction region 4 of the mesa stripe 14. As an alternative to a ternary cap layer, it is possible to use a quaternary InGaAsP cap layer, or both InGaAsP and InGaAs layers.

The wafer is then photolithographically patterned with a photoresist to leave a patterned mask, and etched to remove, in areas not covered by the patterned mask, the ternary cap layer 26 and a portion of the upper cladding layer 24 in order to create a trench 28 in the current conduction region 4 that extends across a central portion of the laser device. The trench is then flanked on opposite sides extending along the length of the mesa 14 by two resulting similar current conduction regions, indicated by 4' and 4" in Figure 1. The trench 28 is about 400 nm deep, and so does not extend down to the level of the DFB grating structure 6. The DFB grating 6 therefore interacts with the optical radiation 7 both in the region of the trench and the adjacent current conduction regions 4',4".

Standard metal layers for electrical contact to the buried heterostructure are then vacuum deposited on the cap layer 26 using well known techniques, followed by metal wet etch in photolithographically defined areas. The remaining metal areas form two contact pads 30',30", one above each of the two similar current conduction regions 4',4", with good ohmic contact through the cap layer 26.

Optionally, the metal layers 30',30" may be deposited before the etching of the trench 28.

The resulting wafer is then thinned to a thickness of about 70 μm to 100 μm in a standard way, in order to assist with cleaving. Standard metal layers are then deposited by sputtering on the rear surface of the wafer, so enabling electrical contact to be made to the n-side of the devices.

The wafer is then inscribed and cleaved in a conventional process first transversely into bars about 350 μm wide, and then each bar is cleaved into individual devices 200 μm wide. The cleaved device 1 is about 350 μm long (i.e. in the direction of the mesa 14) and about 200 μm wide.

Although not shown, after testing the device 1 may be packaged in an industry standard package, with a single mode optical fibre coupled with a spherical lens to an output facet of the laser diode. Gold bond wires 32 are then thermal compression bonded onto the metalised contacts 30',30" so that an electrical current 34 may be applied to power the device 1. In this example, the current 34 is applied equally to both sides of the trench 28.

The InGaAsP/InP device 1 described above therefore incorporates two current confinement regions 20 formed from a reverse-biased p-n structure 17,18. Two similar current conduction regions 4',4" are sandwiched between the current confinement regions 20.

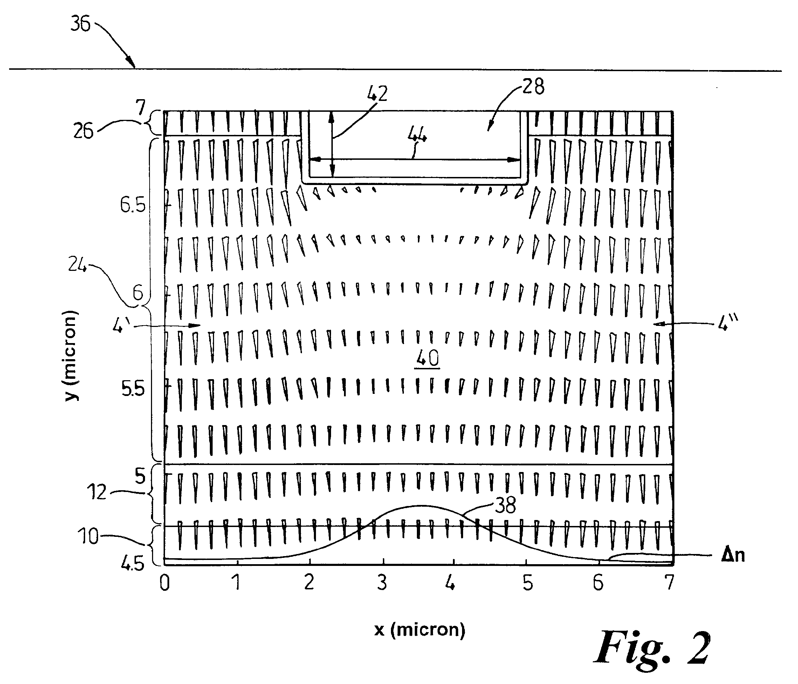

Figure 1 shows schematically how the applied current 34 is constricted in the region of the trench 28. The upper cladding layer 24 is a semiconducting layer, and so does not block the lateral flow of current. Figure 2 shows a vector plot 36 of the result of numerical calculations of the current flow in a longitudinal central plane through the mesa stripe 14. The plot 36 shows the current flow as directed arrows. The small arrow size beneath the trench 28 indicates low current flow.

The calculations show that some current does drift into the upper cladding layer 24 beneath the trench 28, but that the amount of current flowing through the upper cladding layer 24, cladding layer 12 and active layer 10 beneath the trench 28 is reduced compared with the amount directly beneath the two contacts 30', 30". The arrangement of the contacts 30',30" and trench 28 therefore creates a current constriction region 40 in a central portion of the device between the two current conduction regions 4',4". The reduced current results in reduced laser pumping of the active layer 10 in the current constriction region 40.

The local variation in the current 34 leads to a local variation in the refractive index (Δn) 38 along the length of the active layer 10 around constriction region 40, owing to the reduced laser pumping. The refractive index variation 38 subsequently leads to a phase shift relative of the spacing of the DFB grating 6. The size of the phase shift is governed by the equation:

$$\Phi = 2\pi \cdot \Delta nL/\lambda$$

where L is the phase length, Φ is the desired phase shift, λ the emission wavelength, and Δn is the change in refractive index between the pumped and reduced pumped regions.

The refractive index profile is defined mainly by the depth 42 and longitudinal extent 44 of the trench 28, and hence is manufactured into the structure.

The length 44 and refractive index profile 38 can be selected to give phase shifts which lead to single mode operation, that is, phase shifts of $(2n+1)\pi/2$ where n is an integer (n=0,1,2,...). The phase shift Φ can be created in a current constriction region as shown in the drawings, or distributed between several constrictions. In the case of several phase shift regions, the total phase change is the sum of the separate phase shifts. The phase shift Φ does not have to be placed symmetrically along the optical axis of the device.

Although the invention has been described above in relation to a waveguide which is also a lasing medium, the invention is equally applicable to waveguides associated with a DFB structure that do not generate optical radiation by lasing.

The invention described above introduces an optical phase shift in optical radiation generated in the active layer by introducing a fixed current constriction over a relatively small section of the active layer. The invention introduces the optical phase shift without the need for complicated photolithography, electron-beam techniques, or by modifying the local shape or composition of the laser active region. The invention therefore provides a convenient solid state single mode distributed feedback laser.

**Claims**

1. A solid state single mode distributed feedback (DFB) laser (1), comprising a laser waveguide (10), a DFB grating structure (6) optically coupled to the waveguide (10) for stabilising the wavelength of optical radiation (7) in the waveguide (10), one or more current conduction regions (4',4") for guiding an applied electrical current to pump the laser waveguide (10) and at least one current constriction region (40) adjacent said one or more current conduction regions (4',4"), said DFB structure (6) extending in said current constriction region (40) and at least one of said current conduction regions (4',4"), wherein the current conduction and constriction regions (4', 4",40) are arranged so that an electrical current (34) applied to the current conduction region(s) (4',4") pumps the laser waveguide (10) preferentially in said one or more current conduction regions (4',4") compared with the electrical constriction region (40) and thus varies the effective index of refraction (38) of the laser waveguide (10) in said regions (4',4", 40) in order to stabilise said optical radiation (7) for single mode operation of the laser (1).

2. A DFB laser (1) as claimed in Claim 1, in which the DFB structure (6) is based on a regular periodic array of partially reflective features.

3. A DFB laser (1) as claimed in Claim 1 or Claim 2, in which the current constriction region (40) is ion implanted to increase the electrical resistivity of the current constriction region (40) relative to said adjacent current conduction region (4',4").

4. A DFB laser (1) as claimed in Claim 1 or Claim 2, in which the current conduction region (4',4") is formed from one or more semiconductor layers (12,24,26) deposited above the laser waveguide (10), at least one of said deposited layers (26) not extending over the current constriction region (40) .

5. A DFB laser (1) as claimed in any preceding claim, including one or more electrical contacts (30',30") for applying said electrical current (34), in which said one or more contacts (30',30") extend over the current conduction regions (4',4") but not over said current constriction region (40) .

6. A DFB laser (1) as claimed in any preceding claim, in which one current constriction region (40) lies between two adjacent current conduction regions (4', 4").

7. A DFB laser (1) as claimed in Claim 6 when appendant from Claim 5, in which both of said two adjacent current conduction regions (4',4") have an electrical contact (30',30") for applying said current (34).

8. A DFB laser (1) as claimed in Claim 7, in which said two electrical contacts (30',30") are in direct electrical connection.

9. A method of forming a solid state single mode distributed feedback (DFB) laser (1), said laser having a semiconductor substrate (2) and a plurality of layers (8,10,12,17,18,19,24,26) deposited above said substrate, the method comprising the steps of forming in said deposited layers:

   a) a laser waveguide (10);

   b) one or more current conduction regions (4', 4") above said laser waveguide (10) for guiding an applied electrical current (34) to pump the laser waveguide (10);

   c) at least one current constriction region (40) above said laser waveguide (10) and adjacent said one or more current conduction regions (4',4");

   d) a DFB grating structure (6) optically coupled to the waveguide (10) for stabilising the wavelength of optical radiation (7) in said waveguide (10), said structure extending in said current constriction region (40) and at least one of said current conduction regions (4',4");

   wherein said one or more current conduction regions (4',4") and said at least one current constriction region (40) have the characteristic that electrical current (34) applied to said current conduction region(s) pumps the laser waveguide (10) preferentially in said one or more current conduction regions (4',4") compared with said at least one electrical constriction region (40) in order to vary the effective index of refraction (38) of the laser waveguide (10) in said regions (4',4",40) in order to stabilise said optical radiation (7) for single mode operation of the laser (1).

10. A method of operating a solid state distributed feedback (DFB) laser (1), said laser having a laser waveguide (10), a DFB grating structure (6) optically coupled to the waveguide (10) for stabilising the wavelength of optical radiation (7) in the waveguide (10), one or more current conduction regions (4',4") for guiding an applied electrical current (34) to pump the laser (1), the current conduction region(s) (4', 4") extending only within a portion of the DFB grating structure (6), wherein the method comprises applying through said one or more current conduction regions (4',4") an electrical current (34) to pump the laser waveguide (10) unevenly with respect to the extent of the DFB structure (6) and thus vary the effective index of refraction (38) of the laser waveguide (10) in order to stabilise said optical radiation (7) for single mode operation of the laser (1).

*Fig. 1*

EP 1 396 913 A1

*Fig. 2*

EP 1 396 913 A1

**European Patent Office**

## EUROPEAN SEARCH REPORT

Application Number

EP 02 25 6117

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | YOSHIKUNI Y ET AL: "MULTIELCTRODE DISTRIBUTED FEEDBACK LASER FOR PURE FREQUENCY MODULATION AND CHIRPING SUPPRESSED AMPLITUDE MODULATION" JOURNAL OF LIGHTWAVE TECHNOLOGY, IEEE. NEW YORK, US, vol. LT-5, no. 4, 1 April 1987 (1987-04-01), pages 516-522, XP000711148 ISSN: 0733-8724 * page 516, right-hand column, last paragraph; figure 1 * * page 517, left-hand column, paragraph 1 * * page 518, left-hand column, last paragraph; figure 4 * | 1,2,6, 8-10 | H01S5/0625 |
| Y | * page 516-517; figures 1,4 * | 5 | |
| X | MITSUO FUKUDA ET AL: "CONTINUOUSLY TUNABLE MULTISECTION DFB LASER WITH NARROW LINEWIDTH" NTT REVIEW, TELECOMMUNICATIONS ASSOCIATION, TOKYO, JP, vol. 1, no. 4, 1 November 1989 (1989-11-01), pages 90-96, XP000095508 ISSN: 0915-2334 * page 91, left-hand column, paragraph 1; figure 1 * * page 94, left-hand column; figure 5 * * page 93, left-hand column, paragraph 1; figure 6 * * page 93, right-hand column, paragraph 2 * | 1,3,4,7, 9,10 | TECHNICAL FIELDS SEARCHED (Int.Cl.7) H01S |
| Y | US 6 208 793 B1 (KLEPSER BERND ET AL) 27 March 2001 (2001-03-27) * claim 1; figure 1 * | 5 | |

-/--

The present search report has been drawn up for all claims

| Place of search | Date of completion of the search | Examiner |
|---|---|---|
| MUNICH | 16 January 2003 | Laenen, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

**EUROPEAN SEARCH REPORT**

Application Number

EP 02 25 6117

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EP 0 332 453 A (KOKUSAI DENSHIN DENWA CO LTD) 13 September 1989 (1989-09-13) * the whole document * --- | 1,9,10 | |
| A | OKAI M ET AL: "TUNABLE DFB LASERS WITH ULTRA-NARROW SPECTRAL LINEWIDTH" ELECTRONICS LETTERS, IEE STEVENAGE, GB, vol. 29, no. 4, 18 February 1993 (1993-02-18), pages 349-351, XP000346060 ISSN: 0013-5194 * the whole document * ----- | 1,9,10 | |

TECHNICAL FIELDS
SEARCHED (Int.Cl.7)

The present search report has been drawn up for all claims

| Place of search | Date of completion of the search | Examiner |
|---|---|---|
| MUNICH | 16 January 2003 | Laenen, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 02 25 6117

This annex lists the patent family members relating to the patent documents cited in the above-mentioned European search report.
The members are as contained in the European Patent Office EDP file on
The European Patent Office is in no way liable for these particulars which are merely given for the purpose of information.

16-01-2003

| Patent document cited in search report | | Publication date | Patent family member(s) | | Publication date |
|---|---|---|---|---|---|
| US 6208793 | B1 | 27-03-2001 | DE | 19708385 A1 | 03-09-1998 |
| | | | AT | 219609 T | 15-07-2002 |
| | | | AU | 6290198 A | 18-09-1998 |
| | | | WO | 9838711 A1 | 03-09-1998 |
| | | | DE | 59804519 D1 | 25-07-2002 |
| | | | EP | 0976183 A1 | 02-02-2000 |
| | | | JP | 2001513262 T | 28-08-2001 |
| EP 0332453 | A | 13-09-1989 | JP | 1231388 A | 14-09-1989 |
| | | | JP | 2533355 B2 | 11-09-1996 |
| | | | DE | 68908919 D1 | 14-10-1993 |
| | | | DE | 68908919 T2 | 05-01-1994 |
| | | | EP | 0332453 A2 | 13-09-1989 |
| | | | US | 4932034 A | 05-06-1990 |

EPO FORM P0459

For more details about this annex : see Official Journal of the European Patent Office, No. 12/82